(19) **Europäisches Patentamt**

**European Patent Office**

**Office européen des brevets**

(11) **EP 1 049 285 B1**

(12) **FASCICULE DE BREVET EUROPEEN**

(45) Date de publication et mention
de la délivrance du brevet:
**08.11.2006 Bulletin 2006/45**

(51) Int Cl.:
**H04L 7/033** *(2006.01)*

(21) Numéro de dépôt: **00401100.3**

(22) Date de dépôt: **19.04.2000**

(54) **Dispositif d'asservissement de fréquence**

Frequenzregelkreis

Frequency-locked loop

(84) Etats contractants désignés:
**BE DE GB IT NL SE**

(30) Priorité: **30.04.1999 FR 9905627**

(43) Date de publication de la demande:
**02.11.2000 Bulletin 2000/44**

(73) Titulaire: **Fahrenheit Thermoscope LLC
Las Vegas, NV 89119 (US)**

(72) Inventeur: **Majos, Jacques M.
38420 Le Versoud (FR)**

(74) Mandataire: **Cabinet Martinet & Lapoux
43, Boulevard Vauban,
B.P. 405,
Guyancourt
78055 St. Quentin Yvelines Cedex (FR)**

(56) Documents cités:
**EP-A- 0 716 511            US-A- 4 031 478
US-A- 4 912 730**

## EP 1 049 285 B1

**Description**

La présente invention concerne un dispositif d'asservissement de fréquence comprenant une boucle de circuit incluant un oscillateur commandé en tension VCO, asservi par un signal entrant de fréquence instable pour l'extraction d'un signal d'horloge d'un signal numérique à haut débit, ou pour la synthèse de fréquence.

Un asservissement de la fréquence d'un oscillateur VCO est mis en oeuvre dans un récepteur pour extraire d'un signal de données numérique le signal d'horloge initial produit par un émetteur émettant le signal de données. La synthèse de fréquences mettant en oeuvre un oscillateur VCO asservi est utilisée dans des émetteurs radio ou des récepteurs radio où il est nécessaire d'engendrer des fréquences précises pour sélectionner un canal. Dans ces deux applications, le problème technique principal consiste à extraire le signal d'horloge dans le signal de données numérique reçu bruité, c'est-à-dire présentant de la gigue, et de synthétiser une fréquence précise choisie sur la base d'une fréquence de référence instable.

Les applications de l'invention existent dans le domaine des transmissions numériques à hauts débits jusqu'à plusieurs centaines de Mbit/s pour récupérer le signal d'horloge nécessaire au traitement des données reçues et dans le domaine des équipements radio pour la synthèse de fréquences élevées, typiquement jusqu'à quelques GHz.

Dans les deux domaines d'applications cités précédemment, il est classique d'utiliser une boucle de verrouillage de phase PLL (Phase Lock Loop) qui comprend un oscillateur VCO, un diviseur de fréquence pouvant être programmable et relié à la sortie de l'oscillateur pour fournir un signal de fréquence divisée, et un comparateur de phase qui délivre un signal d'erreur issu de la comparaison des phases entre le signal à fréquence divisée et un signal de référence. Le signal d'erreur amplifié puis filtré contrôle l'oscillateur VCO.

Dans la technique antérieure une première difficulté, lorsque la fréquence visée est élevée, est de réaliser un diviseur de fréquence par N nécessaire à la synthèse d'une fréquence quelconque égale à k.N.Fr où k est une constante, N un coefficient variable et Fr la fréquence du signal de référence. Si N est un entier, des fréquences multiples de la fréquence Fr du signal de référence sont engendrées par l'oscillateur VCO. Cependant il est courant de ne pas limiter N à des valeurs entières ce qui augmente la complexité du diviseur de fréquence inclus dans la boucle et conduit à des impossibilités techniques de réalisation à haute fréquence.

Une deuxième difficulté résulte de la nécessité de fournir un signal de référence très stable au comparateur de phase ; dans le cas contraire, le bruit du signal de référence se retrouve multiplié par k.N dans le signal synthétisé sortant de l'oscillateur.

La demande de brevet européen EP-A-0 716 511 a pour objet un indicateur de verrouillage notamment de fréquence pour contrôler l'état de verrouillage de fréquence d'une boucle de verrouillage de phase PLL, dans laquelle un détecteur de phase applique à un filtre de boucle un signal de "pompage" de tension en réponse aux fronts montants du signal de référence de fréquence et un signal de "dépompage" de tension en réponse aux fronts montants du signal de retour de boucle via un diviseur de fréquence par N.

L'indicateur de verrouillage de fréquence est un circuit numérique comprenant un premier circuit de retard retardant le signal de référence après division de fréquence par 2 et des première et troisième bascules D pour échantillonner le signal de pompage par les fronts montants et descendants du signal de référence retardé, et un deuxième circuit de retard retardant le signal de retour de boucle après division de fréquence par 2 et des deuxième quatrième bascules D pour échantillonner le signal de dépompage par les fronts montants et descendants du signal de retour retardé. Une porte NON-OU aux sorties Q des bascules signale par une sortie à l'état haut une relative stabilité en fréquence.

Cet indicateur de verrouillage de fréquence ne remédie donc pas à l'instabilité en fréquence du signal de référence entrant dans la boucle.

L'invention vise à surmonter les difficultés précitées en fournissant un dispositif d'asservissement de fréquence qui est basé sur une comparaison des fréquences entre un signal numérique entrant instable en fréquence d'horloge et un signal d'horloge généré directement ou indirectement par un oscillateur VCO, et qui est mis en oeuvre aussi bien pour de l'extraction d'horloge que pour de la synthèse de fréquence, afin de tolérer une variation de la fréquence du signal entrant autour d'une valeur moyenne sans effet sur le signal d'horloge à extraire ou sur le signal d'horloge à synthétiser dont la fréquence reste stable même en présence d'une forte gigue dans le signal entrant.

A cette fin, un dispositif d'asservissement de fréquence comprenant un moyen oscillant commandé en tension générant un signal d'horloge, dans lequel la fréquence du signal d'horloge et la fréquence instable d'un signal entrant numérique sont comparées, est caractérisé en ce qu'il comprend un moyen pour échantillonner le signal d'horloge à deux couples d'instants correspondants à deux transitions consécutives du signal entrant en réponse à chacune de transitions prédéterminées du signal entrant, les instants dans un couple étant séparés par un retard prédéterminé au plus égal à la demi-période du signal d'horloge, afin de produire quatre signaux d'état du signal d'horloge, et un comparateur de fréquence combinant les quatre signaux d'état en un signal de comptage seulement lorsque la fréquence du signal d'horloge est inférieure à la fréquence du signal entrant et en un signal de décomptage seulement lorsque la fréquence du signal d'horloge est supérieure à la fréquence de signal entrant, et un moyen pour compter et décompter les transitions prédéterminées du signal entrant respectivement en réponse au signal de comptage et au signal de décomptage afin d'appliquer une tension de commande dépendant du contenu du moyen pour compter et décompter au moyen oscillant.

La comparaison de fréquence selon l'invention est effectuée sur la base de deux transitions du signal entrant et non sur une transition généralement pour une comparaison de phase connue. La combinaison des quatre signaux d'état résultant de l'échantillonnage du signal entrant aux deux couples d'instants pour chaque transition peut être réalisé par un moyen pour produire le signal de comptage tant que trois signaux d'état correspondant à des instants consécutifs d'échantillonnage du signal d'horloge sont identiques, et par un moyen pour produire le signal de décomptage tant que l'un des signaux d'état correspondant à des instants d'échantillonnage du signal d'horloge compris entre les instants d'échantillonnage du signal d'horloge correspondant aux deux autres signaux d'état est différent des trois autres signaux d'état.

Selon une réalisation préférée, les fonctions des deux moyens précités pour produire sont mises en oeuvre dans le comparateur de fréquence grâce à une première porte OU-EXCLUSIF recevant deux signaux d'état correspondant à des instants d'échantillonnage du signal d'horloge encadrant les instants d'échantillonnage du signal d'horloge correspondant aux deux autres signaux d'état, une deuxième porte OU-EXCLUSIF recevant les deux autres signaux d'état, une première porte ET reliée directement à la première porte OU-EXCLUSIF et à travers un inverseur à la deuxième porte OU-EXCLUSIF pour produire le signal de comptage, et une deuxième porte ET reliée directement à la deuxième porte OU-EXCLUSIF et à travers un inverseur à la première porte OU-EXCLUSIF pour produire le signal de décomptage.

Le moyen pour échantillonner comprend de préférence un moyen pour détecter les transitions prédéterminées dans le signal entrant afin de produire un signal de transition et un signal de transition retardé dudit retard prédéterminé, et deux couples de bascules produisant respectivement les signaux d'état. Chaque couple de bascules comprend une première bascule recevant le signal d'horloge et une deuxième bascule ayant une entrée reliée à la sortie directe de la première bascule. Le signal de transition et le signal de transition retardé sont appliqués respectivement aux entrées d'horloge des couples de bascules.

Particulièrement, lorsque le signal entrant est un signal d'horloge à fréquence instable, le moyen pour échantillonner est entièrement numérique. Dans ce cas, le moyen pour détecter les transitions comprend un diviseur de fréquence par quatre pour produire un signal d'horloge à la demi-fréquence du signal entrant, et des moyens numériques pour sélectionner une transition du signal entrant et une transition dans un signal complémentaire du signal entrant pendant une demi-période sur deux du signal d'horloge à demi-fréquence afin de produire respectivement le signal de transition et le signal de transition retardé.

Lorsque le dispositif d'asservissement de fréquence sert à extraire un signal d'horloge dans un signal numérique entrant de données bruité, le dispositif comprend un moyen relié au moyen pour échantillonner pour comparer les phases du signal entrant et du signal d'horloge en fonction de deux des quatre signaux d'état afin de sélectionner un signal d'horloge sortant parmi le signal d'horloge et le signal complémentaire de celui-ci qui est le plus en phase avec le signal entrant pour lire le signal entrant. De cette manière, le signal d'horloge sortant est le signal d'horloge récupéré, initialement produit par l'émetteur.

Selon une réalisation préférée, le moyen pour comparer les phases comprend un moyen logique à bascule de verrouillage sélectionnant le signal d'horloge et le signal complémentaire lorsque les signaux d'état produits par les premières ou deuxièmes bascules des couples de bascules sont respectivement à des premier et deuxième états et aux deuxième et premier états.

Lorsque le dispositif d'asservissement de fréquence sert à synthétiser des fréquences, il comprend un moyen de division de fréquence programmable pour générer, en tant que signal entrant à appliquer au moyen pour échantillonner, un signal d'horloge de référence instable ayant une fréquence moyenne sur un nombre respectif de périodes égale à une fréquence programmée, à partir d'un signal d'horloge unitaire ayant une fréquence stable au moins supérieure au quadruple de la fréquence programmée, le rapport de la fréquence programmée et du nombre respectif de périodes étant constant.

La fréquence du signal d'horloge unitaire est ainsi supérieure au quadruple de la plus haute fréquence qui peut être programmée dans le diviseur de fréquence programmable.

Le signal d'horloge de référence présente une fréquence variable résultant de la division programmée entière ou non entière de la fréquence stable du signal d'horloge unitaire, par exemple délivré par une horloge à quartz. La variation de la fréquence de signal de référence est inhibée dans la boucle d'asservissement comprenant principalement le moyen pour échantillonner, le comparateur de fréquence, le moyen pour compter et décompter et l'oscillateur, si bien que la fréquence synthétisée produite par l'oscillateur est la fréquence souhaitée stable qui est égale à un multiple de la moyenne de la fréquence d'horloge de référence. Comparativement à la technique antérieure, le diviseur de fréquence programmable dans les boucles de synthèse connues peut être remplacé selon l'invention par un diviseur de fréquence fixe.

Le moyen de division de fréquence programmable comprend selon une réalisation préférée de l'invention un additionneur, et un registre tampon rythmé à la fréquence du signal d'horloge unitaire et enregistrant une somme aux sorties de l'additionneur, l'additionneur additionnant ladite somme audit nombre respectif associé à la fréquence programmable.

Afin de supprimer toute distorsion de rapport cyclique dans le signal d'horloge de référence, le moyen de division de fréquence programmable comprend un diviseur de fréquence par deux recevant le bit de poids fort de ladite somme depuis le registre tampon pour générer le signal d'horloge de référence.

Particulièrement pour l'application concernant la synthèse de fréquence, le moyen oscillant peut comprendre au moins un oscillateur commandé en tension par le moyen pour compter et décompter à travers un filtre de boucle et un diviseur de fréquence pour diviser la fréquence du signal généré par l'oscillateur par un rapport fixe afin de produire ledit signal d'horloge. Le rapport fixe est de préférence une puissance de deux. Le filtre de boucle filtre notamment des harmoniques du signal d'horloge unitaire résultant de la division de fréquence dans le diviseur de fréquence programmable.

D'autres caractéristiques et avantages de la présente invention apparaîtront plus clairement à la lecture de la description suivante de plusieurs réalisations préférées de l'invention en référence aux dessins annexés correspondants dans lesquels :

- la figure 1 est un bloc-diagramme schématique d'un circuit d'extraction d'horloge selon l'invention ;
- la figure 2 montre en détail un circuit d'échantillonnage inclus dans le circuit d'extraction d'horloge de la figure 1 ;
- la figure 3 montre en détail un comparateur de phase inclus dans le circuit d'extraction d'horloge de la figure 1 ;
- la figure 4 montre en détail un comparateur de fréquence inclus dans le circuit d'extraction d'horloge de la figure 1 ;
- la figure 5 est un bloc-diagramme d'un synthétiseur de fréquence selon l'invention ;
- la figure 6 montre en détail un diviseur de fréquence programmable inclus dans le synthétiseur de fréquence de la figure 5 ; et
- la figure 7 montre en détail un circuit d'échantillonnage inclus dans le synthétiseur de fréquence de la figure 5.

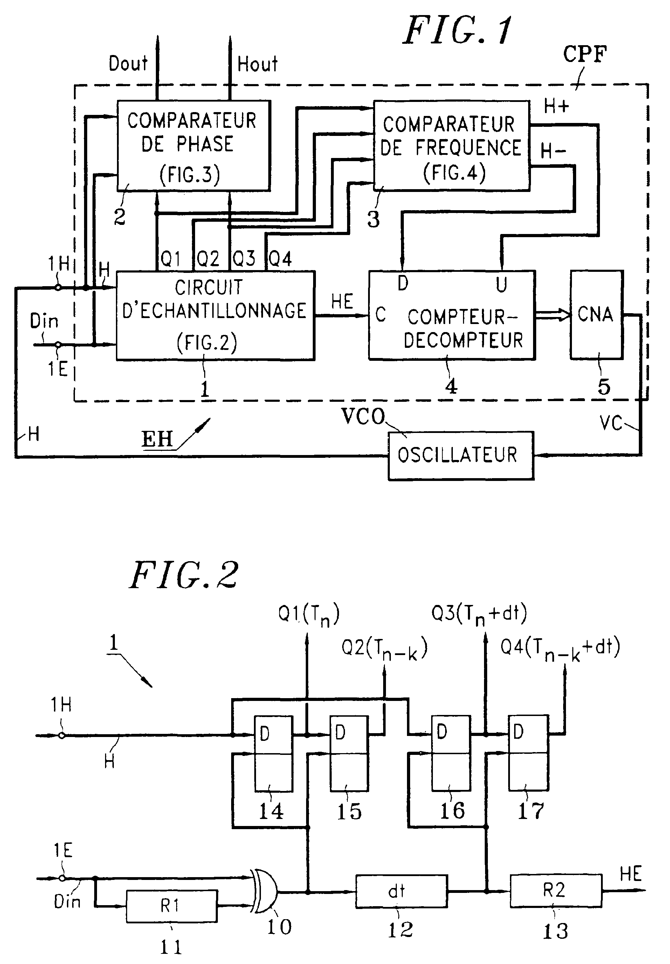

En référence à la figure 1, un dispositif d'asservissement de fréquence en tant que **circuit d'extraction d'horloge** EH dans un récepteur ou terminal de télécommunication comprend un comparateur de phase et de fréquence CPF et un oscillateur commandé en tension VCO. Le comparateur CPF a deux entrées auxquelles sont appliqués un signal numérique de données entrant Din qui est remis en forme après transmission depuis un émetteur de télécommunication, et un signal d'horloge H fourni par l'oscillateur VCO. Dans le comparateur CPF, la comparaison des phases des signaux Din et H produit un signal de données sortant Dout et un signal d'horloge sortant récupéré Hout qui sont synchrones et en phase. La comparaison des fréquences des signaux Din et H dans le comparateur CPF produit un signal de commande analogique à tension variable VC pour commander directement en tension l'oscillateur VCO, afin de générer le signal d'horloge H ayant une fréquence mis à la fréquence moyenne d'horloge du signal de données Din.

Dans le comparateur de phase et de fréquence CPF, la comparaison de phase est réalisée au moyen d'un circuit d'échantillonnage à quatre états 1 et d'un comparateur de phase 2, et la comparaison de fréquence est réalisée au moyen du circuit d'échantillonnage 1, d'un comparateur de fréquence 3, d'un compteur-décompteur 4 et d'un convertisseur numérique-analogique (CNA) 5.

En référence à la figure 2, le **circuit d'échantillonnage** 1 comprend une porte OU-EXCLUSIF 10 ayant des entrées reliées à la borne d'entrée 1E du circuit EH pour le signal de données Din respectivement directement et à travers une ligne à retard 11, et une sortie reliée à deux lignes à retard en cascade 12 et 13. La troisième ligne à retard 13 fournit un signal d'échantillonnage HE à une entrée d'horloge C du compteur-décompteur 4. A travers une entrée de signal d'horloge 1H du circuit d'échantillonnage 1, le signal d'horloge H fourni par l'oscillateur VCO est appliqué à des entrées de données de premières bascules 14 et 16 de deux couples de bascule D en cascade 14-15 et 16-17. Les entrées d'horloge des bascules 14 et 15 du premier couple sont reliées à la sortie de la porte OU-EXCLUSIF 10, et les entrées d'horloge des bascules 16 et 17 du deuxième couple sont reliées à la sortie de la deuxième ligne à retard 12. Dans chaque couple, la sortie Q de la première bascule 14, 16 est reliée à l'entrée D de la deuxième bascule 15, 17. Les sorties Q des bascules 14 à 17 constituent respectivement des sorties Q1 à Q4 du circuit d'échantillonnage à quatre états 1 reliées respectivement à quatre entrées du comparateur de fréquence 3. Seulement les sorties Q1 et Q3 des premières bascules 14 et 16 des couples dans le circuit d'échantillonnage sont reliées à deux entrées de sélection d'horloge du comparateur de phase 2.

Le circuit d'échantillonnage 1 fournit au comparateur de phase 2 et au comparateur de fréquence 3 l'état du signal d'horloge H produit par l'oscillateur VCO pour chaque transition du signal de données entrant Din.

Les transitions montantes et descendantes du signal de données Din sont détectées avec la porte OU EXCLUSIF 10 et la première ligne à retard 11 qui impose sur l'une des entrées de la porte 10 un retard faible R1 par rapport à la demi-période nominale du signal de données entrant Din appliqué directement à l'autre entrée de la porte 10. Le retard R1 définit la largeur des impulsions d'échantillonnage dans le signal de transition à la sortie de la porte OU-EXCLUSIF 10. L'impulsion d'échantillonnage fournie par la sortie de la porte 10 à chaque changement d'état du signal de données Din commande l'enregistrement de l'état du signal d'horloge H dans les quatre bascules de type D 14 à 17.

En variante, au lieu de détecter les transitions montantes et descendantes du signal Din, seulement les transitions montantes, ou seulement les transitions descendantes sont détectées. Par exemple, en introduisant un inverseur après la ligne à retard 11 et en remplaçant la porte OU-EXCLUSIF 10 par une porte ET, des transitions prédéterminées descendantes sont détectées.

Les bascules 14 et 15 enregistrent l'état du signal H en réponse à une transition du signal de données Din à un instant $T_n$ et à un instant $T_{n-k}$ en réponse à la transition précédente du signal Din, respectivement. L'entier k désigne un nombre variable d'intervalles élémentaires de bit ou demi-intervalles élémentaires dans le signal Din séparant deux transitions successives. Les bascules 16 et 17 enregistrent également deux autres états du signal H mais avec un retard prédéterminé dt imposé par un signal de transition retardé par la deuxième ligne à retard 12 ; ainsi la bascule 16 enregistre l'état du signal H au temps $T_n$ + dt, et la bascule 17 enregistre l'état du signal H au temps $T_{n-k}$ + dt. Le retard dt conféré par la ligne à retard 12 est au plus égal à TH/2, TH étant la période du signal d'horloge H à échantillonner.

La troisième ligne à retard 13 impose un retard R2 afin que le signal d'échantillonnage HE appliqué à une entrée d'horloge du compteur-décompteur 4 soit mis en phase avec deux signaux logiques H+ et H- fournis par le comparateur de fréquence 3, ces trois signaux HE, H+ et H- étant appliqués au compteur-décompteur 4.

Chaque ligne à retard peut être réalisée avec une chaîne d'inverseurs.

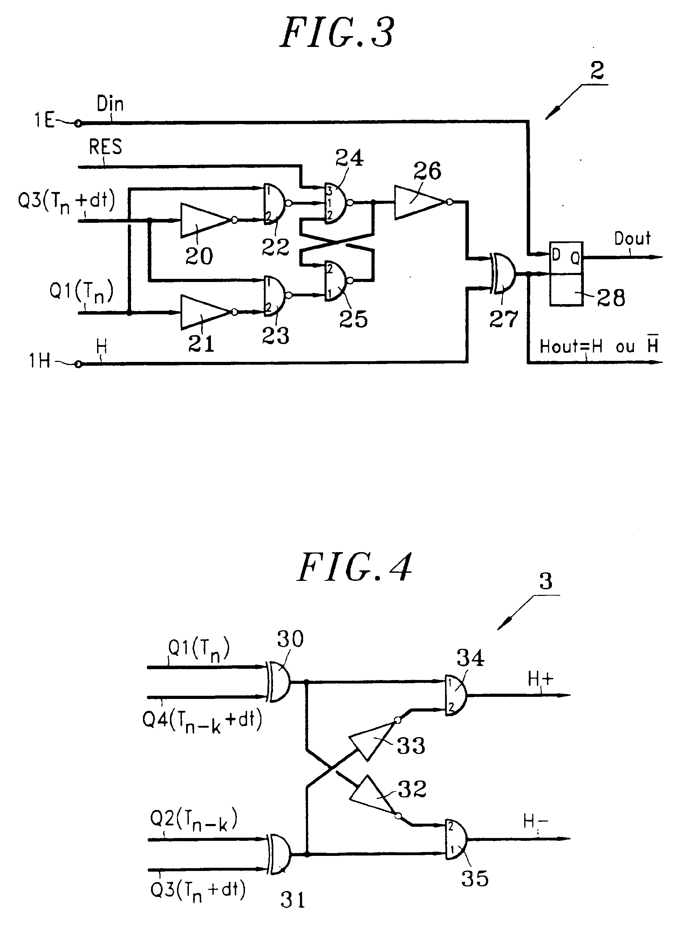

En se référant maintenant à la figure 3, le **comparateur de phase** 2 comprend essentiellement une bascule à verrouillage composée de deux inverseurs 20 et 21, deux portes NON-ET à deux entrées 22 et 23 et deux portes NON-ET 24 et 25 respectivement avec trois et deux entrées, ainsi qu'un inverseur 26, une porte OU-EXCLUSIF 27 et une bascule D 28.

La sortie Q1 de la première bascule 14 du circuit d'échantillonnage 1 est reliée directement à une première entrée de la porte NON-ET 22 et à travers l'inverseur 21 à une deuxième entrée de la porte NON-ET 23. De manière symétrique aux liaisons précédentes, la sortie Q3 de la première bascule 16 du deuxième couple dans le circuit d'échantillonnage 1 est reliée directement à une première entrée de la porte 23 et à travers l'inverseur 20 à une deuxième entrée de la porte 22. Comme dans une bascule RS, des premières entrées des portes NON-ET 24 et 25 sont reliées respectivement aux sorties des portes 22 et 23, et des deuxièmes entrées des portes 24 et 25 sont reliées respectivement aux sorties des portes 25 et 24. Une entrée de remise à zéro RES (Reset) du comparateur de phase 2 est reliée à une troisième entrée de la porte NON-ET 24 et sert à initialiser le comparateur de phase lors de la mise sous tension du dispositif EH en forçant à l'état "1" la sortie de la porte 24. La sortie de la porte 24 est reliée également à travers l'inverseur 26 à une première entrée de la porte OU-EXCLUSIF 27 dont une deuxième entrée reçoit le signal d'horloge H de l'oscillateur VCO. La sortie de la porte 27 fournit le signal d'horloge récupéré Hout à l'entrée d'horloge de la bascule 28. L'entrée D de la bascule 28 est confondue avec l'entrée 1E du circuit d'échantillonnage 1 et reçoit le signal de données entrant Din. La sortie Q de la bascule 28 fournit le signal de données Dout en phase avec le signal d'horloge Hout.

Le comparateur de phase 2 choisit parmi le signal H et le complément $\overline{H}$ de celui-ci, le signal d'horloge qui est le plus en phase avec le signal de données Din pour lire le signal de données entrant Din, sachant que le signal d'horloge H est supposé être à la "bonne" fréquence, c'est-à-dire en synchronisme avec la fréquence moyenne du signal de données Din grâce au traitement dans le comparateur de fréquence 3 décrit plus loin. Pour cela, la bascule de verrouillage 20-25 recherche un front du signal d'horloge H pendant chaque intervalle de temps dt.

Lorsque Q1 = 0 et Q3 = 1, la première entrée de la porte NON-ET 24, c'est-à-dire l'entrée R de la bascule RS 24-25, est à l'état "1" et les signaux H et Din deviennent sensiblement en phase; la sortie de la porte 24 est mise à l'état "0" et la porte 27 sélectionne le signal complémentaire $\overline{H}$ pour lire le signal de données Din dans la bascule 28. Inversement, lorsque Q1 = 1 et Q3 = 0, la première entrée de la porte NON-ET 25, c'est-à-dire l'entrée S de la bascule RS 24-25, est à l'état "1" et les signaux H et Din deviennent sensiblement en opposition de phase ; la sortie de la porte 24 est mise à l'état "1" et la porte 27 sélectionne le signal d'horloge H pour lire le signal de données Din dans la bascule 28. Lorsque Q1 = Q3 = "0", ou lorsque Q1 = Q3 = "1", les premières entrées des portes 24 et 25 sont toutes deux à l'état "1" ; l'état précédent de la sortie de la porte 24 est maintenue, et le signal $\overline{H}$ ou H sélectionné précédemment par la porte 27 est conservé. Dans ce dernier cas, le choix effectué reste correct même si le signal de données Din contient de la gigue qui a une amplitude maximale Gmax égale à TH/2 - dt.

Les états logiques du comparateur de phase 2 commentés ci-dessous sont résumés dans la table de vérité suivante :

| Q1 | Q3 | Sortie 24 | Hout |
|----|----|-----------|------|
| 0 | 0 | inchangé | inchangé |
| 0 | 1 | 0 | $\overline{H}$ |
| 1 | 0 | 1 | H |
| 1 | 1 | inchangé | inchangé |

En variante, les entrées des inverseurs 20 et 21 respectivement reliées aux premières entrées des portes NON-ET 23 et 22 sont reliées aux sorties Q4 et Q2 du circuit d'échantillonnage, à la place des sorties Q3 et Q1.

Dans le **comparateur de fréquence** 3, l'état du signal d'horloge H dans un intervalle de temps dt est analysé, non pas sur une transition $T_n$ comme dans le comparateur de phase 2, mais sur deux transitions consécutives $T_{n-k}$ et $T_n$ du signal de données Din. Cette analyse nécessite les quatre bascules 14 à 17 dans le circuit d'échantillonnage 1 pour enregistrer, en réponse à chaque transition du signal Din détectée par la porte 10, les états Q2 et Q4 du signal d'horloge H aux instants successifs $T_{n-k}$ et $T_{n-k}$ + dt correspondant à une première transition précédant ladite chaque transition et les états Q1 et Q3 du signal d'horloge H aux instants successifs $T_n$ et $T_n$ + dt correspondant à une deuxième transition confondue avec ladite chaque transition.

Si trois états consécutifs sur quatre sont identiques, soit $\overline{Q2} = Q4 = Q1 = Q3$ ou $Q2 = Q4 = Q1 = \overline{Q3}$, une période du signal d'horloge H est contenu dans une période du signal de données Din et le signal H est trop rapide, c'est-à-dire est en avance de phase par rapport au signal de données Din. Si seulement l'un des états intermédiaires Q4 et Q1 du signal H aux instants $T_{n-k}$ + dt et $T_n$ est différent des trois autres, soit $Q2 = \overline{Q4} = Q1 = Q3$ ou $Q2 = Q4 = \overline{Q1} = Q3$, la période du signal H est plus grande que celle du signal Din et le signal H est trop lent, c'est-à-dire le signal H est en retard de phase par rapport au signal de données Din. Par contre, lorsque les états Q1 et Q3 sont identiques et les états Q2 et Q4 sont identiques, ou bien lorsque les états Q1 et Q3 sont différents et les états Q2 et Q4 sont différents, les signaux H et Din sont quasiment à la même fréquence, en phase ou en quadrature de phase, ou exceptionnellement à des fréquences très différentes (hors bande).

Par exemple, si aux instants $T_{n-k}$ et $T_{n-k}$ + dt, le signal H est aux états Q2 = "0" et Q4 = "1" et si aux instants suivants $T_n$ et $T_n$ + dt le signal H est aux états Q1 = "1" et Q3 = "1" respectivement, le comparateur de fréquence 3 en déduit que le signal H est trop rapide.

La table de vérité du comparateur de fréquence 3 est alors la suivante :

| $T_n$ | $T_n$+dt | $T_{n-k}$ | $T_{n-k}$+dt | | | |
|---|---|---|---|---|---|---|
| Q1 | Q3 | Q2 | Q4 | Décision | H- | H+ |
| 0 | 0 | 1 | 0 | H trop rapide | 1 | 0 |
| 0 | 0 | 0 | 1 | H trop lent | 0 | 1 |
| 0 | 0 | 0 | 0 | pas de correction | 0 | 0 |
| | | | | | | |
| 0 | 0 | 1 | 1 | pas de correction | 0 | 0 |
| 0 | 1 | 1 | 1 | H trop lent | 0 | 1 |
| 0 | 1 | 0 | 0 | H trop rapide | 1 | 0 |
| 0 | 1 | 0 | 1 | pas de correction | 0 | 0 |
| 0 | 1 | 1 | 0 | H hors bande | 0 | 0 |
| | | | | | | |
| 1 | 0 | 1 | 1 | H trop rapide | 1 | 0 |
| 1 | 0 | 0 | 0 | H trop lent | 0 | 1 |
| 1 | 0 | 1 | 0 | pas de correction | 0 | 0 |
| 1 | 0 | 0 | 1 | H hors bande | 0 | 0 |
| | | | | | | |
| 1 | 1 | 1 | 0 | H trop lent | 0 | 1 |
| 1 | 1 | 0 | 1 | H trop rapide | 1 | 0 |
| 1 | 1 | 1 | 1 | pas de correction | 0 | 0 |
| 1 | 1 | 0 | 0 | pas de correction | 0 | 0 |

Dans la table ci-dessus, la décision "hors bande" signifie que le signal de données reçu Din est à une fréquence beaucoup trop grande ou trop petite et en dehors de la bande d'accrochage de l'oscillateur VCO, ou contient une gigue non conforme. Dans ce cas, de préférence, un circuit logique (non représenté) assurant la fonction logique $(\overline{Q1}.Q3.Q2.\overline{Q4} + Q1.\overline{Q3}.\overline{Q2}.Q4)$ et relié aux quatre sorties Q1 à Q4 du circuit d'échantillonnage 1 produit un signal d'erreur.

La table de vérité ci-dessus satisfait les équations logiques suivantes :

$$\mathtt{H+ \ = \ (Q1.\overline{Q4} \ + \ \overline{Q1}.Q4)(Q2.Q3 \ + \ \overline{Q2}.\overline{Q3})}$$

$$\mathtt{H- \ = \ (Q2.\overline{Q3} \ + \ \overline{Q2}.Q3)(Q1.Q4 \ + \ \overline{Q1}.\overline{Q4})}$$

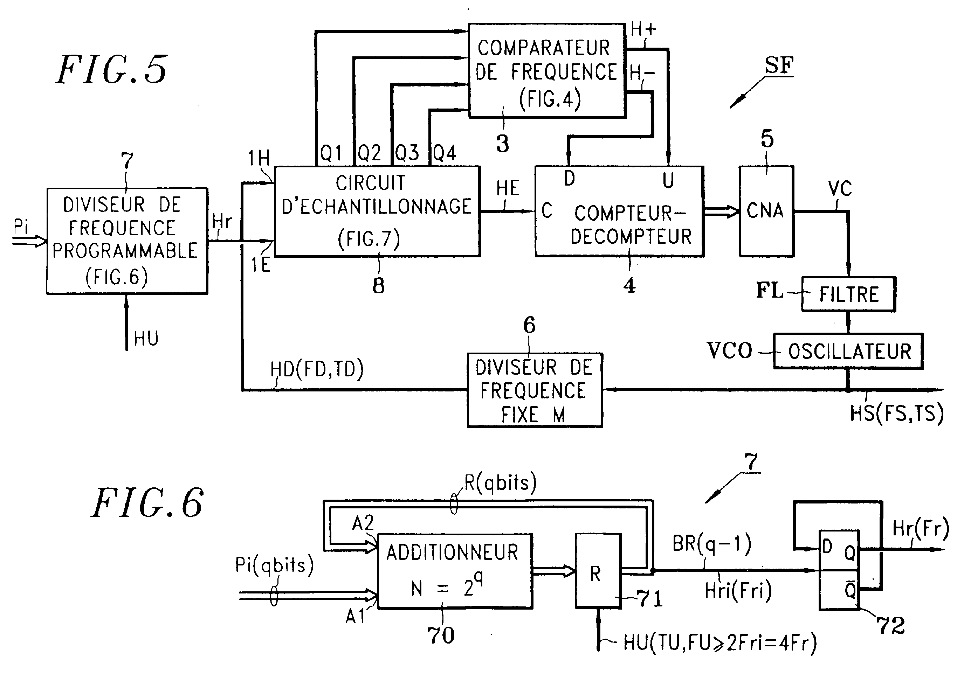

En conformité avec les deux équations logiques ci-dessus, le comparateur de fréquence 3 montré à la figure 4 comprend deux portes OU-EXCLUSIF 30 et 31, deux inverseurs 32 et 33 et deux portes ET à deux entrées 34 et 35. Les sorties Q1 et Q4 du circuit d'échantillonnage 1 sont reliées aux entrées de la porte 30, et les sorties Q2 et Q3 du circuit d'échantillonnage 1 sont reliées aux entrées de la porte 31. La sortie de la porte 30 est reliée directement à une première entrée de la porte 34 et à travers l'inverseur 32 à une deuxième entrée de la porte 35. De manière symétrique, la sortie de la porte 31 est reliée directement à une première entrée de la porte 35 et à travers l'inverseur 33 à une deuxième entrée de la porte 34. Les sorties des portes 34 et 35 fournissent respectivement les signaux logiques H+ et H-.

Ainsi, le comparateur de fréquence 3 analyse le sens de l'erreur entre le rythme du signal de données entrant Din et le rythme du signal d'horloge H de l'oscillateur VCO. Le sens de cette erreur est ainsi représenté par les états de signaux logiques H+ et H-qui sont appliqués respectivement à une entrée de comptage U et une entrée de décomptage D du compteur-décompteur 4.

Le signal logique de comptage H+ tant qu'il est à l'état "1", met en mode de comptage le compteur-décompteur 4 afin que chaque impulsion du signal d'échantillonnage HE incrémente d'une unité le compteur-décompteur et ainsi augmente la tension de commande VC de l'oscillateur VCO pour accroître la fréquence du signal d'horloge H qui était trop lent. Réciproquement, le signal logique de décomptage H-tant qu'il est à l'état "1", met en mode de décomptage le compteur-décompteur 4 afin que chaque impulsion du signal d'échantillonnage HE décrémente d'une unité le compteur-décompteur et ainsi diminue la tension de commande VC de l'oscillateur VCO pour décroître la fréquence du signal d'horloge H qui était trop rapide. Le compteur-décompteur "lisse" ainsi les fluctuations de la fréquence d'horloge du signal entrant pour que l'oscillateur VCO fonctionne en moyenne sur une longue durée à la fréquence moyenne de cette fréquence d'horloge. Le convertisseur numérique-analogique 5 convertit le contenu numérique variable du compteur-décompteur 4 en la tension de commande VC appliquée à l'entrée de commande de l'oscillateur VCO.

La capacité du compteur-décompteur 4 dépend de la précision souhaitée pour la fréquence produite par l'oscillateur VCO.

Si le signal de données Din présente de la gigue, l'amplitude de cette gigue peut atteindre la valeur crête Gmax telle que Gmax= TD/2 - dt, où TD est la période correspondant au débit du signal de données entrant Din.

Selon une deuxième réalisation de dispositif d'asservissement de fréquence selon l'invention, le dispositif est un **synthétiseur de fréquence** SF comme montré à la figure 5. Dans le synthétiseur, on retrouve un circuit d'échantillonnage 8 qui est de préférence modifié par rapport au circuit d'échantillonnage 1 comme cela sera vu ci-après, le comparateur de fréquence 3, le compteur-décompteur 4, le convertisseur numérique-analogique 5, un filtre passe-bas de boucle FL et l'oscillateur commandé en tension VCO. Un diviseur de fréquence fixe 6 relie la sortie de l'oscillateur VCO produisant un signal d'horloge synthétisé HS à l'entrée de signal d'horloge 1H de l'échantillonneur 8. Le diviseur 6 divise par un rapport entier M la fréquence du signal synthétisé HS pour produire un signal d'horloge divisé HD.

Ainsi le synthétiseur de fréquence SF réalise une comparaison de fréquence avec des circuits disposés en boucle, comme dans le dispositif d'extraction d'horloge EH.

Le synthétiseur de fréquence SF comprend également un diviseur de fréquence programmable 7 pour appliquer un signal d'horloge de référence Hr à fréquence programmable à l'entrée de signal de données entrant 1E du circuit d'échantillonnage 8.

Dans le synthétiseur de fréquence SF, la fréquence FS du signal d'horloge HS issu de l'oscillateur VCO est divisée par le rapport entier fixe M dans le diviseur de fréquence 6. M est un entier et est de préférence une puissance de 2. Si Fr dénote la fréquence du signal d'horloge de référence Fr, FS est égal à Fr.M en régime établi de l'oscillateur VCO.

Pour obtenir un ensemble de I fréquences ordonnées FS1,... FSi,... FSI avec l'indice entier i tel que $1 \leq i \leq I$ et FSi < FS(i+1), il faut synthétiser autant de fréquences Fr1, ... Fri, ... FrI de signaux de référence Hr1, ... Hri, ... HrI, avec Fri < Fr(i+1). Pour synthétiser les fréquences de référence de manière précise au moyen d'un diviseur de fréquence connu qui comprend un compteur binaire, il faudrait commander ce diviseur par un signal d'horloge dont la fréquence serait égale au plus petit commun multiple (PPCM) des fréquences Fr1, ... Fri, ... FrI, ce qui est quasiment impossible à réaliser particulièrement lorsque l'entier I est grand et les fréquences Fr1 à FrI sont élevées.

Le synthétiseur de fréquence SF selon l'invention est fondé sur l'hypothèse que les fréquences de référence Frl, ... Fri, ... FrI ont un plus grand commun diviseur entier (PGCD) p tel que Pl = Fr1/p,... Pi = Fri/p,... PI = FrI/p sont des nombres entiers, et calcule la période Tri du signal de référence souhaité Hri en fonction du nombre Pi sélectionné. Soit TU une unité de période pour le calcul de la période du signal de référence sélectionné telle que TU $\leq$ TrI = 1/FrI, et FB = Fr1 la fréquence la plus basse synthétisable obtenue pour P1 = I. La période TB correspondant à la fréquence FB contient le plus grand nombre de périodes TU parmi toutes les périodes correspondant aux fréquences de référence Fr1 à FrI ; soit N ce nombre entier. On en déduit les relations suivantes :

$$TB = N.TU = 1/p,$$

l'unité de fréquence FU = 1/TU = p.N et
la période de signal de référence sélectionné Tri = 1/Fri = TU.N/Pi.

Il en résulte que calculer la période Tri du signal de référence Hri revient à calculer combien de fois le nombre Pi est contenu dans le nombre N. Pour cela, l'invention propose d'additionner le nombre Pi à lui-même au rythme TU jusqu'à obtenir le nombre N et de produire à chaque calcul un échantillon de valeur "0" si le résultat du calcul est inférieur à N/2 et un échantillon de valeur "1" dans le cas contraire.

Toutefois le nombre Pi associé à la fréquence Fri du signal de référence Hri à synthétiser n'est pas forcément un diviseur entier de l'entier N à l'issu du calcul. Soit $r_1$, $r_2$, $r_3$... $r_{Pi}$ des débordements inférieurs à Pi apparaissant dans la dernière unité de période TU pour la première période Tri, pour la deuxième période Tri succédant à la première, puis pour la troisième période Tri succédant à la deuxième, jusqu'à la (Pi)ième période. Les "périodes" successives Tri s'écrivent :

- première période Tri : $T_1 = TU(N+r_1)/Pi$ ;
- deuxième période Tri : $T_2 = TU(N-r_1+r_2)/Pi$ ;
- troisième période Tri : $T_3 = TU(N-r_2+r_3)/Pi$ ;
- Pième période Tri : $T_{Pi} = TU(N-r_{Pi-1}+r_{Pi})/Pi$, les nombres $(N+r_1)$, $(N-r_1+r_2)$, $(N-r_2+r_3)$, ..., $(N-r_{Pi-1}+r_{Pi})$ étant des multiples entiers de Pi. Le dernier débordement rPi est égal à zéro puisque la somme de ces derniers nombres NPi + rpi est un multiple de Pi.

Ainsi la somme de Pi périodes synthétisées consécutives Tri est égale à N.TU et la période moyenne engendrée sur la durée N.TU est égale à

$$\text{Moyenne de Tri} = \overline{Tri} = TU.N/Pi.$$

La moyenne des périodes engendrées par le synthétiseur est bien égale à la valeur souhaitée Tri. Le signal engendré est modulé en fréquence puisqu'à chaque cycle de calcul correspondant à la première, ou deuxième, ou troisième, ..., ou Pième période Tri, une période Tri est engendrée à TU près. L'amplitude maximum de la gigue est donc égale à TU. Comme cela a été précisé ci-dessus, le comparateur de fréquence 3 admet une gigue maximale égale à la demi-période du signal de référence Hr appliqué à l'entrée 1E du circuit d'échantillonnage 8. L'inégalité TU $\leq$ TrI/2 doit être respectée, TrI étant la plus petite période de l'ensemble des périodes Tr1 à TrI; soit FU $\geq$ 2.FrI pour que le synthétiseur fonctionne.

D'autre part le signal engendré par les additions cycliques ne présente pas un rapport cyclique égal à 0,5. Il est nécessaire de diviser la fréquence de ce signal par deux pour supprimer la distorsion de rapport cyclique ; cette condition est respectée en appliquant l'inégalité FU $\geq$ 2.FrI = 4.Fr.

La figure 6 illustre le diviseur de fréquence programmable 7 présentant les caractéristiques fonctionnelles développées ci-dessus. Il comprend un additionneur 70 ayant deux ports d'entrées A1 et A2, un registre tampon 71 et un diviseur de fréquence par 2 comprenant une bascule 72. L'additionneur 70 a de préférence une capacité en puissance de deux, soit N = $2^q$, et reçoit à des premières entrées A1 l'entier Pi codé sur q bits pour programmer la fréquence à synthétiser Fri et additionne l'entier Pi à un résultat R codé sur q bits appliqué aux deuxièmes entrées A2 de celui-ci à travers le registre 71. Le registre 71 a un port d'entrées relié au port de sorties de l'additionneur 70, ses q sorties reliées au deuxième port d'entrée A2 de l'additionneur, et sa sortie de bit de poids fort BR(q-1) reliée à l'entrée d'horloge de la bascule 72. Le registre 71 est rythmé par un signal d'horloge HU ayant une fréquence supérieure à 4Fr. Le signal d'horloge HU est stable et généré par une horloge à quartz, typiquement de quelques mégahertz, constituant une source de fréquence pure à très faible bruit. La bascule 72 forme un diviseur de fréquence par 2 et a une sortie complémentaire $\bar{Q}$ reliée à son entrée D et fournit par une sortie Q le signal d'horloge de référence sélectionné Hr.

Le signal de référence Hr est modulé en fréquence à cause de sa génération dans le diviseur de fréquence programmable 7 dans lequel la fréquence programmée Fri n'est obtenue qu'en moyenne toutes les Pi périodes Tri = 1/Fri. La boucle d'asservissement en fréquence contenant le comparateur de fréquence 3, montrée à la figure 5, stabilise la fréquence programmée FS dans le signal d'horloge HS délivré par l'oscillateur VCO malgré les variations du signal de référence Hr, à la valeur moyenne souhaitée de la fréquence Fr = Fri/2 du signal de référence. Ainsi, les variations périodiques en fréquence du signal de référence sont sans effet sur la fréquence FS utilisée en sortie du synthétiseur SF de l'invention.

En se référant à nouveau à la figure 6, le mot binaire Pi à q bits et le résultat cumulé R délivré par le registre 71, qui enregistre au rythme de l'unité de fréquence FU du signal d'unité de période TU le mot sortant de l'additionneur, sont ainsi additionnés cycliquement à la fréquence FU. Le diviseur de fréquence programmable 7 ne contient pas de comparateur numérique pour déterminer la fréquence Fri du signal d'horloge Hri, avant la division par 2 dans la bascule 72, par comparaison de R et N. L'invention utilise l'état du bit de poids fort BR (q-1) du mot de résultat R en sortie du registre 71 pour former le signal Hri, BR(0) étant le bit de poids faible du mot R. Si le résultat R est inférieur à N/2, alors BR(q-1) est à l'état logique "0" ; sinon BR(q-1) est à l'état logique "1" ; puis le signal d'horloge de référence Hr est produit par la sortie Q de la bascule 72 en divisant par deux la fréquence du signal de bit de poids fort BR(q-1).

En résumé, les équations du diviseur de fréquence programmable sont les suivantes :

$FU_{min} = 2.Frl$
$N_{min} = FU_{min}/p$,
N étant de préférence tel que $N=2^q > N_{min}$ ;
$FU = p.N$
$Tri = TU.N/Pi = 1/(p.Pi)$
$Fri = p.Pi$.

Un exemple numérique est présenté ci-après. Soit un oscillateur VCO qui doit engendrer les fréquences FS égales à 1200 ; 1250 ; 1300 ; 1350 et 1400 MHz. Sachant que le diviseur 6 de la boucle de synthèse a un rapport de division fixe M égal à 1024, les fréquences de signal de référence Fr à synthétiser sont égales à 1,171875 ; 1,220703125 ; 1,26953125 ; 1,318359375 et 1,3671875 MHz. Compte-tenu de la division par deux dans la bascule 72 pour obtenir le signal d'horloge de référence Hr en sortie du diviseur 7, les fréquences à engendrer sont les suivantes :

Fr1 = 2,34375 ; 2,44140625 ; 2,5390625 ; 2,63671875 et Frl = Fr5 = 2,734375 MHz. Le pas p du synthétiseur est donc égal à 0,09765625 MHz, $FU_{min}$ égale à 2(2,734375) MHz = 5,468875 MHz et $N_{min}$ égal à $FU_{min}/P$ = 56.

On en déduit :

$N = 2^6 = 64$ et q = 6
HQ = N.p = 6,25 MHz
P1=24 ; P2=25 ; P3=26 ; P4=27 ; P5=28.

Par exemple pour Pi = 26, la fréquence de référence est Fr = Fri/2 = p.Pi/2 = 1,26953125 MHz.

Dans le **circuit d'échantillonnage** 8 dans le synthétiseur de fréquence SF, le signal périodique de référence Hr est appliqué sur l'entrée de données Din 1E, et le signal d'horloge HD issu du diviseur de fréquence par M 6 relié à l'oscillateur VCO est appliqué sur l'entrée 1H, Fr étant la fréquence du signal d'horloge Hr échantillonnant le signal HD ayant la fréquence FD après division par M de la fréquence HS du signal d'horloge synthétisé FS. On a alors la relation Fr = 2.FD = 2(FS/K), soit FS = Fr(K/2).

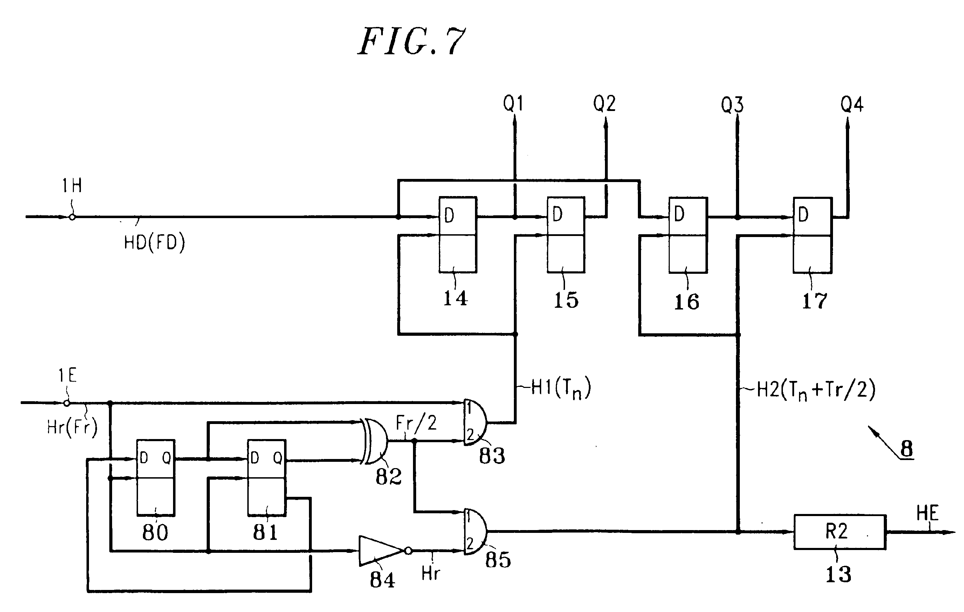

Selon une réalisation préférée montrée en figure 7, le circuit d'échantillonnage 8 comprend des moyens numériques pour produire un signal de transition H1 et un signal de transition retardé H2 décalé d'un retard dt pour échantillonner le signal d'horloge HD appliqué à l'entrée 1H. Le circuit d'échantillonnage 8 comprend, comme le circuit d'échantillonnage 1, la ligne à retard 13 et les deux couples de bascule 14-15 et 16-17, et à la place des lignes à retard 11 et 12 et de la porte OU-EXCLUSIF 10 dans le circuit 1 (figure 2), des moyens entièrement numériques 80-85. Les moyens numériques se trouvent après l'entrée 1E qui reçoit le signal d'horloge de référence Hr fourni par le diviseur de fréquence programmable 5, c'est-à-dire qui reçoit, après division par deux, l'un des signaux d'horloge Tr1 à Trl sélectionné en fonction de l'entier Pi codé sur q bits appliqué à la première entré A1 de l'additionneur 70 (figure 6), et produisent les signaux d'horloge H1 et H2 vers les entrées d'horloge des couples de bascule 14-15 et 16-17 respectivement.

Les moyens numériques 80-85 utilisent une fréquence Fr plus élevée que celles des signaux de transition H1 et H2 servant à l'échantillonnage, et divise la fréquence Fr pour obtenir la bonne fréquence FD aux entrées d'horloge des bascules d'échantillonnage 14 à 17. Cette division permet de parfaitement contrôler le retard dt.

Le diviseur de fréquence programmable 7 délivrant le signal de référence Hr avec une gigue maximale égale à Tr/2, il faut pour absorber cette gigue que le retard dt soit tel que :

$$dt = TD/4 - Tr/2,$$

où TD est la période du signal d'horloge à l'entrée 1H. Comme la période TD est obtenue à partir de la période Tr du signal de référence Hr par division entière M, on a la relation : TD = M.Tr,
de laquelle est déduite le retard

dt = M.Tr/4 - Tr/2. Pour le plus petit retard dt=Tr/2 qui peut être réalisé en circuit numérique à partir d'un signal de période Tr, M=4 déduit de la relation ci-dessus est la solution optimale.

Selon la réalisation montrée à la figure 7, les moyens numériques précités 80-85 comprennent un diviseur de fréquence par 4 comportant deux bascules D 80 et 81 et un circuit logique comprenant une porte OU-EXCLUSIF 82, deux portes ET à deux entrées 83 et 85, et un inverseur 84 pour produire les deux signaux de transition H1 et H2 à la fréquence FD = Fr/2. Les entrées d'horloge des bascules 80 et 81, une première entrée de la porte ET 83 et l'entrée de l'inverseur 84 reçoivent le signal d'horloge Hr. Les bascules 80 et 81 formant un diviseur de fréquence par quatre, la sortie complémentaire $\overline{Q}$ de la deuxième bascule 81 est reliée à l'entrée D de la première bascule 80. Les sorties Q des bascules 80 et 81 produisent deux signaux logiques à la fréquence Fr/4 et déphasés de 2Tr et sont reliées respectivement aux entrées de la porte OU-EXCLUSIF 82. La sortie de la porte 82 produit ainsi un signal à la fréquence Fr/2 et est reliée à une deuxième entrée de la porte ET 83 et à une première entrée de la porte ET 85 ayant une deuxième entrée reliée à la sortie de l'inverseur 84. Les créneaux de largeur Tr du signal de période 2Tr à la sortie de la porte OU-EXCLUSIF 82 sélectionne une période du signal Hr sur deux dans la porte ET 83 pour constituer le signal de transition H1 de largeur Tr/2 et de période 2Tr appliqué aux entrées d'horloge des bascules 14 et 15 du premier couple.

Les créneaux du signal à la sortie de la porte 82 sélectionne également une période du signal complémentaire $\overline{Hr}$ sur deux dans la porte ET 85 pour constituer le signal de transition H2 identique au signal H1 mais retardé de dt = Tr/2 par rapport à celui-ci et appliqué aux entrées d'horloge des bascules 16 et 17 du deuxième couple, ainsi que de la ligne à retard 13 qui fournit le signal d'échantillonnage HE appliqué à l'entrée d'horloge du compteur-décompteur 4.
Les deux signaux d'horloge H1 et H2 échantillonnent le signal HD issu de l'oscillateur VCO après division par M, à des instants $T_n$ et $T_n$ + Tr/2.

### Revendications

1.   Dispositif d'asservissement de fréquence comprenant un moyen oscillant commandé en tension (VCO; FL, VCO, 6) générant un signal d'horloge, dans lequel la fréquence du signal d'horloge (H ; HD) et la fréquence instable d'un signal entrant numérique (Din ; Hr) sont comparées, **caractérisé en ce qu'**il comprend un moyen (1 ; 8) pour échantillonner le signal d'horloge (H ; HD) à deux couples d'instants correspondant à deux transitions consécutives du signal entrant en réponse à chacune de transitions prédéterminées du signal entrant (Din ; Hr), les instants dans un couple étant séparés par un retard prédéterminé (dt) au plus égal à la demi-période du signal d'horloge, afin de produire quatre signaux d'état (Q2, Q4 ; Q1, Q2) du signal d'horloge, et un comparateur de fréquence (3) combinant les quatre signaux d'état en un signal de comptage (H+) seulement tant que la fréquence du signal d'horloge est sensiblement inférieure à la fréquence du signal entrant et en un signal de décomptage (H-) seulement tant que la fréquence du signal d'horloge est supérieure à la fréquence de signal entrant, et un moyen (4, 5) pour compter et décompter des transitions prédéterminées (HE) du signal entrant respectivement en réponse au signal de comptage (H+) et au signal de décomptage (H-) afin d'appliquer une tension de commande (VC) dépendant du contenu du moyen pour compter et décompter au moyen oscillant à travers un convertisseur analogique-numérique (5).

2.   Dispositif conforme à la revendication 1, dans lequel le comparateur de fréquence comprend un moyen (30, 31, 33, 34) pour produire le signal de comptage (H+) tant que trois des signaux d'état correspondant à des instants consécutifs d'échantillonnage du signal d'horloge (H ; HD) sont identiques, et un moyen (30, 31, 32, 35) pour produire le signal de décomptage (H-) tant que l'un des deux signaux d'état correspondant à des instants d'échantillonnage du signal d'horloge (H ; HD) compris entre les instants d'échantillonnage du signal d'horloge correspondant aux deux autres signaux d'état est différent des trois autres signaux d'état.

3.   Dispositif conforme à la revendication 1 ou 2, dans lequel le comparateur de fréquence (3) comprend une première porte OU-EXCLUSIF (30) recevant deux signaux d'état correspondant à des instants d'échantillonnage du signal d'horloge (H ; HD) encadrant les instants d'échantillonnage du signal d'horloge correspondant aux deux autres signaux d'état, une deuxième porte OU-EXCLUSIF (31) recevant les deux autres signaux d'état, une première porte ET (34) reliée directement à la première porte OU-EXCLUSIF et à travers un inverseur (33) à la deuxième porte OU-EXCLUSIF pour produire le signal de comptage (H+), et une deuxième porte ET (35) reliée directement à la deuxième porte OU-EXCLUSIF (31) et à travers un inverseur (32) à la première porte OU-EXCLUSIF pour produire le signal de décomptage (H-).

4. Dispositif conforme à l'une quelconque des revendications 1 à 3, dans lequel le moyen pour échantillonner (1 ; 8) comprend un moyen (10, 11, 12 ; 80-85) pour détecter les transitions prédéterminées dans le signal entrant (Din ; Hr) afin de produire un signal de transition (H1) et un signal de transition (H2) retardé dudit retard prédéterminé (dt), et deux couples de bascules produisant respectivement les signaux d'état et ayant chacun une première bascule (14, 16) recevant le signal d'horloge (H ; HD) et une deuxième bascule (15, 17) ayant une entrée reliée à la sortie directe de la première bascule, le signal de transition (H1) et le signal de transition retardé (H2) étant appliqués respectivement à des entrées d'horloge des couples de bascules (14-15 ; 16-17).

5. Dispositif conforme à la revendication 4, dans lequel le moyen pour détecter les transitions est numérique et comprend un diviseur de fréquence par quatre (80, 81, 82) pour produire un signal d'horloge à la demi-fréquence du signal entrant (Hr), et des moyens (83, 85) pour sélectionner une transition du signal entrant (Hr) et une transition dans un signal complémentaire $(\overline{Hr})$ du signal entrant pendant une demi-période sur deux du signal d'horloge à demi-fréquence afin de produire respectivement le signal de transition (H1) et le signal de transition retardé (H2).

6. Dispositif conforme à l'une quelconque des revendications 1 à 5, comprenant un moyen (2) relié au moyen pour échantillonner (1) pour comparer les phases du signal entrant (Din) et du signal d'horloge (H) en fonction de deux des quatre signaux d'état afin de sélectionner parmi le signal d'horloge (H) et le signal complémentaire (H̄) de celui-ci un signal d'horloge sortant qui est le plus en phase avec le signal entrant et qui sert à lire le signal entrant.

7. Dispositif conforme aux revendications 4 et 6, dans lequel le moyen pour comparer les phases comprend un moyen logique à bascule de verrouillage (20-27) sélectionnant le signal d'horloge (H) et le signal complémentaire (H̄) lorsque les signaux d'état produits par les premières ou deuxièmes bascules (14, 16 ; ou 15, 17) des couples de bascules sont respectivement à des premier et deuxième états et aux deuxième et premier états.

8. Dispositif conforme à l'une quelconque des revendications 1 à 7, comprenant un moyen de division de fréquence programmable (7) pour générer, en tant que signal entrant à appliquer au moyen pour échantillonner (8), un signal d'horloge de référence instable (Hr) ayant une fréquence moyenne sur un nombre respectif (Pi) de périodes égale à une fréquence programmée, à partir d'un signal d'horloge unitaire (HU) ayant une fréquence stable au moins supérieure au quadruple de la fréquence programmée, le rapport de la fréquence programmée et du nombre respectif de périodes étant constant.

9. Dispositif conforme à la revendication 8, dans lequel le moyen de division de fréquence programmable comprend un additionneur (70), et un registre tampon (71) rythmé à la fréquence du signal d'horloge unitaire (HU) et enregistrant une somme (R) aux sorties de l'additionneur, l'additionneur additionnant ladite somme (R) audit nombre respectif (Pi) associé à la fréquence programmée.

10. Dispositif conforme à la revendication 9, dans lequel le moyen de division de fréquence comprend un diviseur de fréquence par deux (72) recevant le bit de poids fort (BR(q - 1)) de ladite somme depuis le registre tampon (71) pour générer le signal d'horloge de référence (Hr).

11. Dispositif conforme à l'une quelconque des revendications 1 à 10, dans lequel le moyen oscillant comprend au moins un oscillateur (VCO) commandé en tension par le moyen pour compter et décompter (4, 5) à travers un filtre de boucle (FL), et un diviseur de fréquence (6) pour diviser la fréquence du signal généré par l'oscillateur par un rapport fixe afin de produire ledit signal d'horloge (HD).

**Claims**

1. A frequency control device comprising voltage-controlled oscillator means (VCO; FL, VCO, 6) generating a clock signal, wherein the frequency of the clock signal (H ; HD) and the unstable frequency of a digital incoming signal (Din ; Hr) are compared, **characterized in that** it comprises means (1 ; 8) for sampling the clock signal (H ; HD) at two pairs of times corresponding to two consecutive transitions of the incoming signal in response to each of predetermined transitions of the incoming signal (Din ; Hr), the times of one pair being separated by a predetermined time-delay at most equal to half the period of the clock signal to produce four state signals (Q2, Q4 ; Q1, Q2) of the clock signal, and a frequency comparator (3) combining the four state signals into an upcounting signal (H+) only when the frequency of the clock signal is substantially less than the frequency of the incoming signal and into a downcounting signal (H-) only when the frequency of the clock signal is greater than the frequency of the incoming signal (H+), and upcounting and downcounting means (4, 5) for upcounting and downcounting predetermined transitions (HE) of the incoming signal respectively in response to the upcounting signal and the downcounting signal in order to apply a control voltage (VC) depending on a content of the upcounting and downcounting means (H-) to the oscillator means (VCO) via an analog-to-digital converter (5).

2. A device as claimed in claim 1 wherein the frequency comparator includes means (30, 31, 33, 34) for producing the upcounting signal (H+) for as long as three of the state signals corresponding to consecutive sampling times of the clock signal (H ; HD) are identical, and means (30, 31, 32, 35) for producing the downcounting signal (H-) for as long as one of the two state signals corresponding to sampling times of the clock signal (H ; HD) lying between sampling times of the clock signal corresponding to the other two state signals is different from the other three state signals.

3. A device as claimed in claim 1 or 2, wherein the frequency comparator (3) includes a first EXCLUSIVE-OR gate (30) receiving two state signals corresponding to sampling times of the clock signal (H ; HD) between which are sampling times of the clock signal corresponding to the other two state signals, a second EXCLUSIVE-OR gate (31) receiving the other two state signals, a first AND gate (34) connected directly to the first EXCLUSIVE-OR gate and via an inverter (33) to the second EXCLUSIVE-OR gate to produce the upcounting signal (H+), and a second AND gate (35) connected directly to the second EXCLUSIVE-OR gate (31) and via an inverter (32) to the first EXCLUSIVE-OR gate to produce the downcounting signal (H-).

4. A device as claimed in any one of claims 1 to 3, wherein the sampling means (1 ; 8) includes means (10, 11, 12 ; 80-85) for detecting the predetermined transitions in the incoming signal (Din ; Hr) in order to produce a transition signal (H1) and another transition signal (H2) delayed by the predetermined time-delay (dt), and two pairs of flip-flops respectively producing the state signals and each having a first flip-flop (14, 16) receiving the clock signal (H ; HD) and a second flip-flop (15, 17) having an input connected to the direct output of the first flip-flop, the transition signal (H1) and the delayed transition signal (H2) being respectively applied to clock inputs of the pairs of flip-flops (14-15 ; 16-17).

5. A device as claimed in claim 4, wherein the transitions detecting means is digital and comprises a divide-by-four frequency divider (80, 81, 82) to produce a clock signal at half the frequency of the incoming signal (Hr), and means (83, 85) for selecting a transition of the incoming signal (Hr) and a transition in the complementary signal $(\overline{Hr})$ of the incoming signal during one half-period in two of the half-frequency clock signal in order to produce the transition signal (H1) and the delayed transition signal (H2), respectively.

6. The device as claimed in any one of claims 1 to 5, further comprising means (2) connected to the sampling means (1) for comparing the phases of the incoming signal (Din) and the clock signal (H) as a function of two of the four state signals in order to select from the clock signal (H) and the complementary signal ($\overline{H}$) thereof an outgoing clock signal which is more in phase with the incoming signal and which is used to read the incoming signal.

7. A device as claimed in claims 4 and 6, phase comparing means comprises latch logic means (20-27) for selecting the clock signal (H) and the complementary signal (H) an outgoing clock signal (H) when the state signals produced by the first or second flip-flops of the pairs of flip-flops (14, 16 ; or 15, 17) are respectively at first and second states and at second and first states.

8. The device as claimed in any one of claims 1 to 7, comprising programmable frequency divider means (7) for generating the incoming signal to be applied to the sampling means (8) in the form of an unstable reference clock signal (Hr) having a mean frequency over a respective number (Pi) of periods equal to a programmed frequency from a unit clock signal (HU) having a stable frequency not less than four times the programmed frequency, the ratio between the programmed frequency and the respective number of periods being constant.

9. A device as claimed in claim 8, wherein the programmable frequency divider means comprises an adder (70), and a buffer register clocked (71) at the frequency of the unit clock signal (HU) and storing a sum (R) at outputs of the adder, the adder adding said sum (R) to said respective number (Pi) associated with the programmed frequency.

10. A device as claimed in claim 9 wherein the frequency divider means comprises a divide-by-two frequency divider (72) receiving a most significant bit (BR(q - 1)) of said sum from the buffer register (71) to generate the reference clock signal.

11. A device as claimed in one any of claims 1 to 10, wherein the oscillator means comprises at least one voltage-controlled oscillator (VCO) controlled by the upcounting and downcounting means (4, 5) via a loop filter (FL), and a frequency divider (6) for dividing the frequency of the signal generated by the oscillator by a fixed ratio in order to generate the clock signal (HD).

**Patentansprüche**

1. Vorrichtung zur Frequenzregelung, ein spannungsgesteuertes Oszillationsmittel (VCO; FL, VCO, 6) umfassend, das ein Taktsignal erzeugt, in der die Frequenz des Taktsignals (H; HD) und die instabile Frequenz eines eingehenden Digitalsignals (Din; Hr) verglichen werden, **dadurch gekennzeichnet, dass** sie ein Mittel (1; 8) zum Abtasten des Taktsignals (H; HD) in zwei Paaren von Zeitpunkten, die zwei aufeinander folgenden Übergängen des eingehenden Signals entsprechen, in Reaktion auf jeden der festgelegten Übergänge des eingehenden Signals (Din; Hr) umfasst, wobei die Zeitpunkte eines Paares durch eine festgelegte Verzögerung voneinander getrennt sind, die höchstens gleich der halben Periode des Taktsignals ist, um vier Taktsignalzustandssignale (Q2, Q4; Q1, Q2) zu erzeugen, und einen Frequenzvergleicher (3), der die vier Zustandssignale nur zu einem Zählsignal (H+) kombiniert, solange die Frequenz des Taktsignals deutlich niedriger ist, als die Frequenz des eingehenden Signals, und zu einem Rückwärtszählsignal (H-) nur, solange die Frequenz des Taktsignals höher ist, als die Frequenz des eingehenden Signals, und ein Mittel (4, 5) zum Zählen und Rückwärtszählen der festgelegten Übergänge (HE) des eingehenden Signals in Reaktion auf das Zähl- (H+) bzw. Rückwärtszählsignal (H-), um an das Oszillationsmittel über einen Analog-Digital-Wandler (5) eine Steuerspannung (VC) anzulegen, die vom Inhalt des Mittels zum Zählen und Rückwärtszählen abhängt.

2. Vorrichtung nach Patentanspruch 1, in der der Frequenzvergleicher ein Mittel (30, 31, 33, 34) umfasst, um das Zählsignal (H+) zu erzeugen, solange drei der Zustandssignale, die aufeinander folgenden Abtastzeitpunkten des Taktsignals (H; HD) entsprechen, identisch sind, und ein Mittel (30, 31, 32, 35) zur Erzeugung des Rückwärtszählsignals (H-), solange eins der beiden Zustandssignale, die Abtastzeitpunkten des Taktsignals (H; HD) entsprechen, die zwischen den Abtastzeitpunkten des Taktsignals liegen, die den beiden anderen Zustandssignalen entsprechen, sich von den drei anderen Zustandssignalen unterscheidet.

3. Vorrichtung nach Patentanspruch 1 oder 2, in der der Frequenzvergleicher 3 ein erstes Antivalenzglied (30) umfasst, das zwei Zustandssignale empfängt, die Abtastsignalen des Taktsignals (H; HD) entsprechen, die die Abtastzeitpunkte des Taktsignals einrahmen, die den beiden anderen Zustandssignalen entsprechen, ein zweites Antivalenzglied (31), das die beiden anderen Zustandssignale empfängt, ein erstes UND-Glied (34), das direkt mit dem ersten Antivalenzglied verbunden ist und über ein NICHT-Glied (33) mit dem zweiten Antivalenzglied, um das Zählsignal (H+) zu erzeugen, und ein zweites UND-Glied (35), das direkt mit dem zweiten Antivalenzglied (31) verbunden ist und über ein NICHT-Glied (32) mit dem ersten Antivalenzglied, um das Rückwärtszählsignal (H-) zu erzeugen.

4. Vorrichtung nach irgendeinem der Patentansprüche 1 bis 3, in der das Abtastmittel (1; 8) ein Mittel (10, 11, 12; 80-85) zur Feststellung der festgelegten Übergänge im eingehenden Signal (Din; Hr) umfasst, um ein Übergangssignal (H1) und ein um die genannte festgelegte Verzögerung (dt) verzögertes Übergangssignal (H2) zu erzeugen und zwei Paare von Kippschaltungen, die die Zustandssignale erzeugen und jeweils eine erste Kippschaltung (14, 16) umfassen, die das Taktsignal (H; HD) empfängt, und eine zweite Kippschaltung (15, 17), die über einen Eingang verfügt, der mit dem direkten Ausgang der ersten Kippschaltung verbunden ist, wobei das Übergangssignal (H1) und das verzögerte Übergangssignal (H2) jeweils an Takteingänge der Kippschaltungspaare (14-15; 16-17) angelegt sind.

5. Vorrichtung nach Patentanspruch 4, in der das Mittel zur Feststellung der Übergänge digital arbeitet und einen durch vier teilenden Frequenzteiler (80, 81, 82) umfasst, um ein Taktsignal mit der halben Frequenz des eingehenden Signals (Hr) zu erzeugen, und Mittel (83, 85) zur Auswahl eines Überganges des eingehenden Signals (Hr) und eines Überganges in einem zum eingehenden Signal komplementären Signal $(\overline{Hr})$ während jeder zweiten Halbperiode des Taktsignals der halben Frequenz, um das Übergangssignal (H1) bzw. das verzögerte Übergangssignal (H2) zu erzeugen.

6. Vorrichtung nach irgendeinem der Patentansprüche 1 bis 5, ein Mittel (2) umfassend, das mit dem Abtastmittel (1) verbunden ist, um die Phasen des eingehenden Signals (Din) und des Taktsignals (H) in Abhängigkeit von zwei der vier Zustandssignale zu vergleichen, um unter dem Taktsignal (H) und dessen komplementärem Signal (H) ein ausgehendes Taktsignal auszuwählen, das mit dem eingehenden Signal am meisten in Phase ist und dazu dient, das eingehende Signal zu lesen.

7. Vorrichtung nach den Patentansprüchen 4 und 6, in der das Mittel zum Vergleich der Phasen ein logisches Mittel mit Verriegelungskippschaltung (20-27) umfasst, das das Taktsignal (H) und das komplementäre Signal ($\overline{H}$) auswählt, wenn die Zustandssignale, die von der ersten oder der zweiten Kippschaltung (14, 16; oder 15, 17) der Kippschaltungspaare erzeugt werden, sich in einem ersten und einem zweiten Zustand befinden bzw. in einem zweiten und einem ersten Zustand.

8. Vorrichtung nach irgendeinem der Patentansprüche 1 bis 7, ein programmierbares Mittel zur Frequenzteilung (7) umfassend, um ausgehend von einem Einheitstaktsignal (HU) mit einer stabilen Frequenz, die mindestens viermal so hoch ist, wie die programmierte Frequenz, ein instabiles Bezugstaktsignal (Hr) als an das Abtastmittel (8) anzulegendes Eingangssignal zu erzeugen, das eine über eine entsprechende Anzahl (Pi) an Perioden gemittelte Frequenz aufweist, wobei das Verhältnis der programmierten Frequenz zur entsprechenden Anzahl an Perioden konstant ist.

9. Vorrichtung nach Patentanspruch 8, in der das programmierbare Mittel zur Frequenzteilung ein Addierglied (70) und ein Pufferregister (71) umfasst, das mit der Frequenz des Einheitstaktsignals (HU) getaktet wird und eine an den Ausgängen des Addiergliedes anliegende Summe (R) speichert, wobei das Addierglied die genannte Summe (R) zur entsprechenden Anzahl (Pi) addiert, die zur programmierten Frequenz gehört.

10. Vorrichtung nach Patentanspruch 9, in der das Mittel zur Frequenzteilung einen durch zwei teilenden Frequenzteiler (72) umfasst, der vom Pufferregister (71) das höchstwertige Bit (BR(q - 1)) der genannten Summe empfängt, um das Bezugstaktsignal (Hr) zu erzeugen.

11. Vorrichtung nach irgendeinem der Patentansprüche 1 bis 10, in der das oszillierende Mittel mindestens einen vom Mittel zum Zählen und Rückwärtszählen (4, 5) über einen Schleifenfilter (FL) spannungsgesteuerten Oszillator (VCO) umfasst und einen Frequenzteiler (6) zur Teilung der Frequenz des vom Oszillator erzeugten Signals durch ein festes Verhältnis, um das genannte Taktsignal (HD) zu erzeugen.

## *FIG.1*

CPF

Dout    Hout

COMPARATEUR
DE PHASE
(FIG.3)

2

COMPARATEUR
DE FREQUENCE
(FIG.4)

3

H+

H−

1H    H

Din

1E

Q1  Q2  Q3  Q4

CIRCUIT
D'ECHANTILLONNAGE
(FIG.2)

1

HE

D         U

C    COMPTEUR-
DECOMPTEUR

4

CNA

5

H

EH

VCO

OSCILLATEUR

VC

## *FIG.2*

1

$Q1(T_n)$

$Q2(T_{n-k})$

$Q3(T_n + dt)$

$Q4(T_{n-k} + dt)$

1H

H

D        D        D        D

14       15       16       17

1E

Din

R1

11

10

dt

12

R2

13

HE

# FIG.3

# FIG.4

*FIG.5*

COMPARATEUR
DE FREQUENCE
(FIG.4)

H+

H−

3

SF

DIVISEUR DE
FREQUENCE
PROGRAMMABLE
(FIG.6)

7

Pi

Hr

HU

1H

1E

CIRCUIT
D'ECHANTILLONNAGE
(FIG.7)

8

Q1 Q2 Q3 Q4

HE

C

COMPTEUR-
DECOMPTEUR

4

D U

CNA

5

VC

FL — FILTRE

VCO — OSCILLATEUR

HD(FD,TD)

DIVISEUR DE
FREQUENCE
FIXE  M

6

HS(FS,TS)

*FIG.6*

7

R(qbits)

A2

Pi(qbits)

ADDITIONNEUR
N = 2^q

70

A1

R

71

BR(q−1)

Hri(Fri)

HU(TU,FU ≥ 2Fri=4Fr)

D  Q

Q̄

Hr(Fr)

72

*FIG.7*

EP 1 049 285 B1